# EUROPÄISCHE PATENTSCHRIFT

(11) **EP 1 404 447 B1**
(45) Veröffentlichungstag und Bekanntmachung des Hinweises auf die Patenterteilung: **17.09.2008**
(21) Anmeldenummer: 02764657.9
(22) Anmeldetag: 09.07.2002
(51) Int. Cl.: B01L 3/00, G01N 27/447

(54) **ANALYSEVORRICHTUNG**
ANALYSIS DEVICE
DISPOSITIF D'ANALYSE

(30) Priorität: 09.07.2001 US 901467; 09.07.2001 AT 10662001
(43) Veröffentlichungstag der Anmeldung: 07.04.2004
(73) Patentinhaber: Greiner Bio-One GmbH, 72636 Frickenhausen (DE)
(72) Erfinder: GERLACH, Andreas, 76133 Karlsruhe (DE); KNEBEL, Günther, 72622 Nürtingen (DE)
(74) Vertreter: Secklehner, Günter
(86) Internationale Anmeldenummer: PCT/EP2002/007629
(87) Internationale Veröffentlichungsnummer: WO 2003/006163

(56) Entgegenhaltungen:
- EP-A- 0 581 413
- US-A- 5 876 675
- US-A- 6 103 199

## Beschreibung

Die Erfindung betrifft eine Analysevorrichtung umfassend einen Grundkörper mit einer Oberfläche, wobei im Grundkörper zumindest eine Analyseeinrichtung angeordnet ist, die aus zumindest zwei Reservoirs, die mit zumindest einem Kanal strömungsverbunden sind, besteht.

Aus Mikrokanälen gebildete Systeme finden in der Mikrosystemtechnik als so genannte mikrofluidische Systeme Anwendungen für miniaturisierte chemische bzw. biochemische Analysesysteme. Anwendungsgebiete derartiger Mikrokanalsysteme sind z.B. die Wirkstoffforschung, die chemische Diagnostik, die Genom-Analyse, die Umweltanalytik und die kombinatorische Chemie. Das besondere Merkmal ist dabei, dass nur sehr kleine Flüssigkeitsmengen transportiert bzw. manipuliert werden. Anwendungsgebiete sind beispielsweise auch Mikroreaktoren, in denen chemische Reaktionen stattfinden, oder Mikrotiterplatten.

Im Falle der Kapillarelektrophorese wird die Probe in einer dünnen Kapillare, deren Breite in der Größenordnung einiger 10 µm liegt, unter Einfluss eines elektrischen Feldes in ihre verschiedenen Komponenten aufgetrennt und analysiert.

Zur Herstellung von Mikrokanalstrukturen werden sowohl Glas als auch Kunststoffe verwendet. So wird z.B. in der WO 98/45693 A1 eine Methode zur Herstellung von Mikrokanalstrukturen beschrieben. Die Mikrokanalstrukturen werden dabei durch eine Grund- und eine Deckplatte gebildet, wobei in einer ebenen Oberfläche der Grundplatte die Mikrokanäle ausgebildet werden, die durch Aufsetzen einer ebenen Oberfläche der Deckplatte verschlossen werden. An den Enden der Mikrokanäle sind in der Deckplatte Öffnungen ausgebildet, durch die die Proben zugeführt werden können.

Um bei den bekannten Mikrokanalstrukturen elektrische Felder auf die Proben einwirken lassen zu können, ist es erforderlich, durch die Öffnungen an den Enden der Mikrokanäle Elektroden einzuführen. Insbesondere wenn eine Vielzahl von Mikrokanalstrukturen auf Mikrotiterplatten angeordnet ist, sind die Öffnungen zum Einbringen der Proben, in die auch die Elektroden einzuführen sind, entsprechend klein auszubilden. Dadurch wird aber ein erhöhtes Maß an Präzision für die mechanische Steuerung zur Zuführung der Elektroden erforderlich. Dies kann zu Störungen bei der Kontaktierung und somit zu Beeinträchtigungen der Funktionssicherheit führen.

Aus dem Dokument WO 00/02038 A1 ist ein Verfahren zur Durchführung von chemischen bzw. biochemischen Analysen unter Verwendung von Mikrokanalsystemen und eine dazu verwendete Apparatur bekannt. Zur Durchführung von Untersuchungen unter Anwendung der Kapillarelektrophorese wird dabei eine so genannte Kapillarelektrophorese-Mikroplatte verwendet, in der eine Vielzahl von Mikrokanalstrukturen ausgebildet sind und eine entsprechende Anzahl von Untersuchungen gleichzeitig durchgeführt werden kann. Die Mikroplatte wird gebildet aus einer jeweils aus Glas hergestellten Grund- und Deckplatte, wobei in eine Oberfläche der Grundplatte die Mikrokanäle eingeätzt sind, die wiederum durch die Deckplatte abgeschlossen werden. In Endbereichen der Kapillaren- bzw. Mikrokanäle sind in der Deckplatte Öffnungen bzw. Bohrungen vorgesehen, durch die die Proben in die Mikrokanäle gefüllt werden können bzw. die Probenflüssigkeit mit Elektroden kontaktiert werden können. Aus der WO 00/02038 A1 ist auch bekannt, elektrisch leitende Verbindungen auf der Mikroplatte anzubringen, durch die die Öffnungen an den Endbereichen der Mikrokanäle nach außen hin elektrisch verbunden werden können. Es ist weiters vorgesehen, dass die Endbereiche der zur Separation der Proben in einem angelegten elektrischen Feld dienenden Mikrokanäle in einem gemeinsamen Anodenreservoir enden. Jene Öffnungen der Mikroplatte, durch die die Probenbefüllung erfolgt sind relativ zueinander mit Abständen angeordnet wie sie den Behälterabständen auf einer Mikrotiterplatte entsprechen.

In dem Dokument WO 98/45693 A1 ist eine Methode zur Herstellung von Mikrokanalstrukturen beschrieben. Diese Mikrokanalstrukturen werden durch eine Grund- und eine Deckplatte gebildet, wobei in einer ebenen Oberfläche der Grundplatte die Mikrokanäle ausgebildet werden, die durch Aufsetzen einer ebenen Oberfläche der Deckplatte verschlossen werden. An den Enden der Mikrokanäle sind in der Deckplatte Öffnungen ausgebildet, durch die Proben zugeführt werden können. Durch die Öffnungen in der Deckplatte ist es auch möglich, die Proben mit entsprechenden Elektroden elektrisch zu kontaktieren.

In US 5,989,402 A wird eine mikrofluidische Vorrichtung beschrieben, bestehend aus einem unteren und einem oberen Teil, wobei auf einem Teil die Reservoirs für die Lösung und am anderen Teil Stifte, welche in die Reservoirs ragen, angeordnet sind. Jeder Stift ist in einem Winkel von 90° angeordnet. Der untere Teil springt vor und auf diesem vorspringenden Teil sind Kontaktstellen angeordnet. Weiters wird beschrieben, dass eine Vielzahl von elektrischen Kontaktpunkten auf dem vorspringenden Teil der Vorrichtung angeordnet sind und dass jeder dieser elektrischen Kontaktpunkte über Drähte mit einer separaten Öffnung verbunden ist. In US 5,989,402 A wird auch beschrieben, dass zwischen zwei Reservoirs Kanäle angeordnet sind, welche sich mit einem Kanal von zwei anderen Reservoirs kreuzen. Diese Kreuzungen können T-Kreuzungen, Kreuz-Kreuzungen, etc. sein. Die Geometrie der Kreuzungen kann beliebig sein.

Die US 6,623,860 B2 beschreibt eine mehrteilige mikrofluidische Vorrichtung, wobei die einzelnen Reservoirs über Kanäle miteinander verbunden sind. Die Kanäle zur Verbindung zweier Reservoirs können sich mit Kanälen zur Verbindung zweier anderer Reservoirs kreuzen. Sobald die Proben in die Reservoirs zugegeben werden, werden Elektroden in die Flüssigkeit, welche sich in den Reservoirs befindet, insertiert. Es wird besehrieben, dass eine fixe Anordnung einer Vielzahl von exakt positionierten Elektroden, genannt "bed of nails" vorliegen muss, um ein elektrisches Feld für die unterschiedlichen Anwendungen für das System zur Verfügung zu stellen.

Die US 5,585,069 A beschreibt eine unterteilte mikroelektronische Vorrichtung. Es wird das Aufbringen einer Flüssigkeit auf die Oberfläche einer "microlaboratory disc" beschrieben. Des Weiteren wird beschrieben, dass mehrere Reservoirs auf einer "microlaboratory disc" angeordnet sind und diese über Kanäle miteinander verbunden sind, und zu einem Modul zusammengefasst werden. Jedes dieser Module ist wiederum mit einem Abfallcontainer verbunden, welcher überschüssige Flüssigkeit sammelt. In US 5,585,069 A wird auch beschrieben, dass auf dem Boden der Reservoirs ein Metall angeordnet sein kann, über welches die Temperatur in dem jeweiligen Reservoir reguliert werden kann. Die Metallschicht am Boden des Reservoirs ist über Leitungen an die Unter- bzw. Oberseite der "microlaboratory disc" verbunden und es kann dadurch die Temperatur sowohl gemessen als auch reguliert werden. In einer alternativen Anordnung werden jeweils zwei oder mehr Elektroden an einander gegenüberliegenden Seiten eines Reservoirs angeordnet und über eine externe Leitung miteinander verbunden, wodurch ein reversibel-magnetisches Feld entsteht und dadurch das Reagenz, welches sich im Reservoir befindet, gerührt bzw. vermischt werden kann. Des Weiteren wird beschrieben, dass durch das Aufsetzen einer Deckplatte auf die "microlaboratory disc" die Flüssigkeit in den Kanälen durch Kapillarwirkung transportiert wird.

Die US 6,086,825 A beschreibt eine Vorrichtung zum vereinfachten Befüllen von mikrofluidischen Systemen, in welchen ein Netzwerk von Kammern durch Kanäle miteinander verbunden ist. Im Speziellen beschreibt US 6,086,825 A eine Vorrichtung, mit welcher die Probleme bzw. Defizite, welche beim Befüllen vom mikrofluidischen Vorrichtungen mit Flüssigkeiten auftreten umgangen werden können. Es wird eine Vorrichtung zum Befüllen dieser mikrofluidischen Strukturen beschrieben, wobei das Befüllen über Nadeln, welche in einem 96er-Raster angeordnet sind, erfolgen kann.

Es ist daher die Aufgabe der Erfindung, eine Analysevorrichtung für elektrochemische bzw. elektrokinetische Untersuchungen zu schaffen, durch die deren Handhabung vereinfacht wird.

Diese Aufgabe der Erfindung wird durch eine Analysevorrichtung umfassend einen Grundkörper mit einer Oberfläche nach Anspruch 1 gelöst. Vorteilhaft ist dabei, daß durch die am Grundkörper der Analysevorrichtung angebrachten elektrischen Leiter bzw. Kontaktstellen die Funktionssicherheit erhöht wird und insbesondere durch die von den Reservoirs der Analyseeinrichtungen distanziert angebrachten Kontaktstellen die Flüssigkeiten bzw. Proben, die sich in den Reservoirs bzw. Kanälen der Analyseeinrichtung befinden, nicht durch das Einführen bzw. Entfernen von Elektroden in bzw. aus den Reservoirs gestört werden.

Vorteilhaft ist weiters die Ausbildung der Analysevorrichtung, wonach der Grundkörper aus einer Bodenplatte und einer Deckplatte gebildet ist, wobei die Bodenplatte und die Deckplatte an Oberflächen miteinander verbunden sind, da dadurch die die Analyseeinrichtung bildenden Kanäle bzw. Reservoirteile durch Ausbildung von Vertiefungen in einer der Oberflächen der Boden- und/oder der Deckplatte hergestellt werden können. Indem die Bodenplatte und die Deckplatte aneinandergefügt und miteinander verbunden werden, lassen sich solcherart die Kanäle auf einfache Weise verschließen, so daß sie nur durch die an ihren Endbereichen befindlichen Reservoirs von außen zugänglich sind.

Durch die Weiterbildung, bei der die Leiter mit dem Grundkörper mit einer Verbindungsmethode verbunden sind, wobei die Verbindungsmethode aus einer Gruppe ausgewählt ist, die die Methoden Kleben, Bedampfen, Einfügen in Vertiefungen und Anformen umfaßt, wird der Vorteil erzielt, daß die Analysevorrichtungen in einer kompakten Form ausgebildet werden können und insbesondere die Gefahr einer Beschädigung der Leiter minimiert ist.

Durch die Weiterbildung der Analysevorrichtung, wonach zumindest ein Teil eines Reservoirbodens durch den Leiter gebildet ist, wird der Vorteil erzielt, daß für den Stromübergang zwischen dem Leiter und der im Reservoir befindlichen Flüssigkeit dieser eine ausreichend große benetzbare Oberfläche des Leiters zur Verfügung steht und somit der Übergangswiderstand gering gehalten werden kann. Eine ausreichend große Leiteroberfläche für den Stromübergang zur Verfügung zu haben, ist bei den geringen Abmessungen der Reservoirs, wie sie für Mikrokanalstrukturen verwendet werden, günstig.

Besonders vorteilhaft ist weiters die Ausbildung der Analysevorrichtung, wonach der erste Endbereich des Leiters durch eine Elektrode ausgebildet ist, die sich zwischen dem Reservoirboden und einer Unterseite der Bodenplatte erstreckt, da sich dadurch besonders einfach strukturierte Analysevorrichtungen herstellen lassen. Durch die von den Reservoirböden zur Unterseite der Bodenplatte reichenden Elektroden ist es nämlich möglich, alle Leiter und deren Kontaktstellen ausschließlich an der Unterseite der Bodenplatte anzuordnen. Wird die Bodenplatte als Kunststoffspritzgußteil hergestellt, bietet sich somit die Möglichkeit, Elektroden, Leiter und deren Kontaktstellen als einstückig ausgebildete Teile herzustellen, diese Teile in eine Spritzgußform einzulegen und so die mit elektrischen Leitern versehene Bodenplatte in einem einzigen Arbeitsschritt zu fertigen.

Durch die Ausbildung der Analysevorrichtung, wobei die Kontaktstellen mit einer Kontaktfläche mit einem Innenkreisdurchmesser und die Reservoirs mit einer Öffnung mit einem Innenkreisdurchmesser ausgebildet sind und der Innenkreisdurchmesser der Kontaktfläche größer ist als der Innenkreisdurchmesser der Öffnungen der Reservoirs, wird der Vorteil erzielt, daß das Kontaktieren der Kontaktstellen mit entsprechenden Spannungsversorgungen wesentlich weniger fehleranfällig erfolgen kann als dies üblicherweise bei den bei Mikrokanalsystemen sehr kleinen Öffnungen der Reservoirs möglich ist.

Vorteilhaft ist auch eine Weiterbildung der Analysevorrichtung, wobei die Kontaktstellen nur an einem gemeinsamen Endbereich des Grundkörpers angeordnet sind, da dadurch zum Kontaktieren der Kontaktstellen entsprechende Adapter verwendet werden können, die nur von einer Seite an die Analysevorrichtung zugeführt werden müssen.

Durch die Weiterbildung der Analysevorrichtung, wonach die Leiter aus einem Werkstoff bestehen, wobei der Werkstoff aus einer Gruppe ausgewählt ist, die die Materialien Metall, elektrisch leitfähiger Kunststoff, Leitfähigkeitspaste und elektrisch leitfähiger Lack umfaßt, wird der Vorteil erzielt, daß dadurch Analysevorrichtungen hergestellt werden können, deren elektrische Leitungen für die Durchführung von Kapillarelektrophoreseuntersuchungen ausreichende elektrische Leitfähigkeit aufweisen.

Von Vorteil sind aber auch Weiterbildungen der Analysevorrichtungen, wonach der Grundkörper gemäß einer Standardgröße einer Mikrotiterplatte ausgebildet ist bzw. eine vorbestimmbare Anzahl von Analyseeinrichtungen angeordnet ist, wobei die Anzahl aus einer Gruppe ausgewählt ist, die die Zahlen, gebildet durch die mathematische Formel 3 x 2^{N}, wobei N eine natürliche Zahl ist, umfaßt. bzw. 96 Analyseeinrichtungen angeordnet sind, da dadurch automatisierte Systeme, wie sie für Mikrotiterplatten üblich sind, zur Durchführung entsprechender Analysen verwendet werden können. So ist z.B. das Befüllen der Reservoirs mit den Proben mit Hilfe standardisierter Pipettiervorrichtungen möglich.

Gemäß den Ausbildungen der Analysevorrichtung, wonach der Kanal als ein Mikrokanal ausgebildet ist bzw. die Analyseeinrichtung mit vier Reservoirs ausgebildet ist und jeweils zwei Reservoirs mit einem Kanal verbunden sind und die beiden Kanäle jeweils durch einen gemeinsamen Kreuzungsbereich miteinander verbunden sind, wird der Vorteil erzielt, daß einerseits in Mikrokanälen durch die Kapillarwirkung sehr homogene Strömungsverhältnisse herrschen und andererseits für die Durchführung von Kapillarelektrophoreseuntersuchungen aus dem Kreuzungsbereich der beiden Kanäle ein sehr kleines Volumen von wenigen 100 pl separiert werden kann.

Die Weiterbildung der Analysevorrichtung, wonach die vier Reservoirs gemäß einem Standardraster einer Mikrotiterplatte angeordnet sind, bietet den Vorteil, daß standardisierte Vorrichtungen zur automatisierten Bedienung von Mikrotiterplatten verwendet werden können.

Gemäß der Weiterbildung der Analysevorrichtung, wonach eine Reihenweite der vier Reservoirs gleich ist einem halben Wert einer Reihenweite der Analyseeinrichtungen, wird der Vorteil erzielt, daß die Reservoirs auf der Analysevorrichtung, gleich verteilt, d.h. mit maximalem Abstand zwischen zwei unmittelbar benachbarten Reservoirs, angeordnet sind.

Vorteilhaft ist weiters auch eine Ausbildung der Analysevorrichtung, wonach die Bodenplatte und die Deckplatte aus Kunststoff bestehen, wobei die Kunststoffe aus einer Gruppe ausgewählt sind, die die Materialien Polymethylmetacrylat, Polycarbonat, Polystyrol, Polysulfon und Cycloolefin-Copolymer umfaßt, da damit durchsichtige Grundkörper von Analysevorrichtungen hergestellt werden können, die eine Detektion der Reaktionen in den Kanälen der Analyseeinrichtungen erlauben.

Eine Weiterbildung der Analysevorrichtung, wobei die Bodenplatte oder die Deckplatte zumindest teilweise lichtundurchlässig ausgebildet ist, bietet den Vorteil, daß dadurch bei der Detektion von fluoreszierenden Probenbestandteilen störendes Streulicht vermieden werden kann.

Von Vorteil ist schließlich auch eine Weiterbildung der Analysevorrichtung, wobei der zumindest eine Kanal durch Vertiefungen in zumindest einer der Oberflächen der Bodenplatte und der Deckplatte ausgebildet ist und zumindest jene Teile der Oberflächen der Bodenplatte und der Deckplatte, die die Reservoirs und die Kanäle unmittelbar umgeben, mit einer Verbindungsmethode miteinander flüssigkeitsdicht verbunden sind, wobei die Verbindungsmethode aus einer Gruppe ausgewählt ist, die die Methoden Verkleben, Aufbringen von polymerisierbaren Bindemitteln, Haftvermittlung durch temporäre Behandlung mit einem Lösungsmittel, thermisches Versiegeln, Ultraschallschweißen und Laserschweißen umfaßt, da dadurch ungestörte homogene Strömungsverhältnisse in den Kanälen erreicht werden.

Die Erfindung wird im nachfolgenden anhand der in den Zeichnungen dargestellten Ausführungsbeispiele näher erläutert.

Es zeigen:
- Fig. 1: eine Analysevorrichtung bestehend aus einer Bodenplatte und einer Deckplatte;
- Fig. 2: eine Ansicht der Analysevorrichtung gemäß Fig. 1;
- Fig. 3: eine Prinzipdarstellung einer Analyseeinrichtung;
- Fig. 4: einen Schnitt einer Analysevorrichtung gemäß Fig. 1;
- Fig. 5: die Bodenplatte;
- Fig. 6: einen Schnitt einer Analysevorrichtung mit einer Kontaktstelle gemäß Fig. 1;
- Fig. 7: die Deckplatte;
- Fig. 8: einen Schnitt einer Analysevorrichtung mit einer Kontaktstelle und Leitern an der Oberseite der Deckplatte gemäß Fig. 1;
- Fig. 9: ein Ausführungsbeispiel einer Analysevorrichtung mit Reservoirs in quadratischem Raster;
- Fig. 10: einen Schnitt einer Analysevorrichtung gemäß Fig. 9;
- Fig. 11: eine Unterseite einer Analysevorrichtung gemäß Fig. 9;
- Fig. 12: eine Prinzipdarstellung einer Analyseeinrichtung gemäß Fig. 9.

Einführen sei festgehalten, daß in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen.

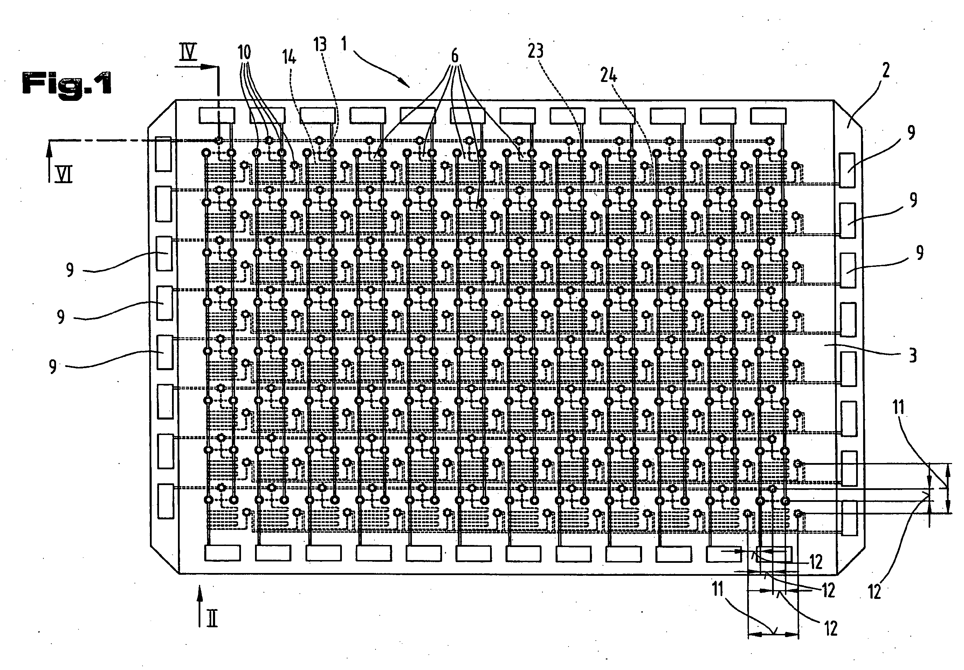

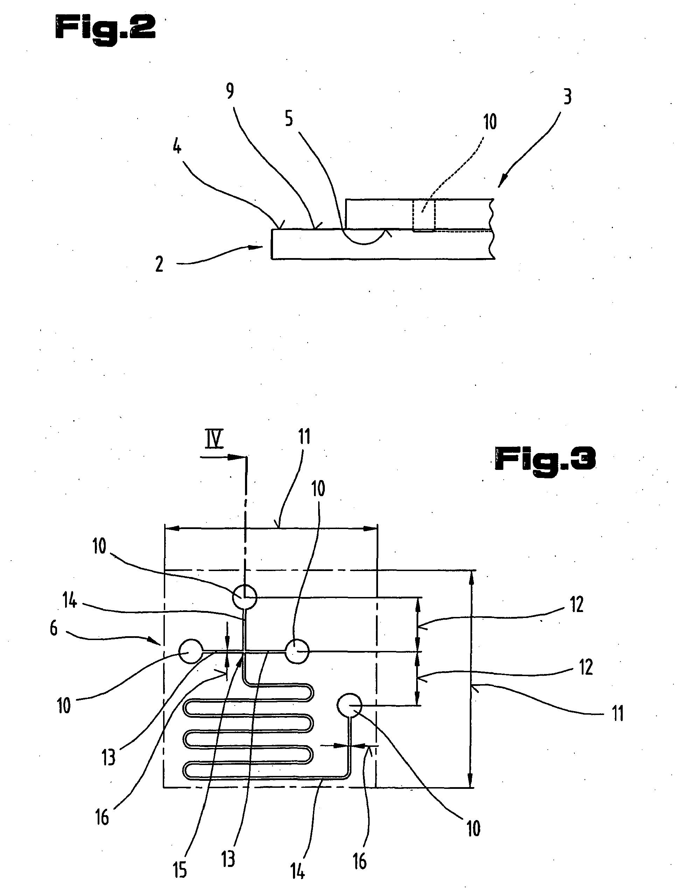

Die Fig. 1 und 2 zeigen eine erfindungsgemäße Analysevorrichtung bestehend aus einem plattenförmigen Grundkörper 1. Der Grundkörper 1 wird durch eine Bodenplatte 2 und eine Deckplatte 3 gebildet, die miteinander an einer Oberfläche 4 der Bodenplatte 2 und einer Oberfläche 5 der Deckplatte 3 miteinander verbunden sind.

Im durch die Bodenplatte 2 und die Deckplatte 3 gebildeten Grundkörper 1 sind insgesamt 96 Analyseeinrichtungen 6 (teilweise strichliert dargestellt) ausgebildet. Die Analyseeinrichtungen 6 dienen zur Durchführung von elektrochemischen Untersuchungen bzw. von Reaktionen. Zur elektrischen Kontaktierung der Analyseeinrichtungen 6 sind an der Oberfläche 4 der Bodenplatte 2 mehrere Kontaktstellen 9 ausgebildet. Die Analyseeinrichtungen 6 verfügen weiters über jeweils vier Reservoirs 10, durch die die Proben und Pufferlösungen zugeführt werden können. Die Reservoirs 10 sind als zylinderförmige Durchgänge in der Deckplatte 3 ausgebildet.

Die äußeren Abmaße des Grundkörpers 1 der Analysevorrichtung sind gemäß einer Standardgröße einer Mikrotiterplatte ausgebildet. Dementsprechend sind auch die Analyseeinrichtungen 6 in einem rechtwinkeligen Raster gemäß einem Standardraster einer Mikrotiterplatte mit 96 Einheiten ausgebildet. Eine Reihenweite 11, d.h. der seitliche Abstand der Analyseeinrichtungen 6 beträgt jeweils 9 mm in Richtung der Längserstreckung des Grundkörpers 1 als auch senkrecht dazu. Der Anordnung der Reservoirs 10 liegt ein rechtwinkeliges Raster mit einer Reihenweite 12 von 2,25 mm zugrunde, d.h. die Reihenweite 12 entspricht einem Viertel der Reihenweite 11 der Analyseeinrichtungen 6 und somit einem Standardraster einer Mikrotiterplatte mit 1536 Einheiten.

Vorteilhaft sind jedoch Anordnungen in einem rechtwinkeligen Raster, insbesondere mit einer Anzahl, die den Anzahlen standardisierter Mikrotiterplatten entsprechen, d.h. die Anzahl gebildet ist durch die mathematische Formel 3 x 2^{N}, wobei N eine natürliche Zahl ist.

In einer möglichen Weiterbildung kann der Grundkörper 1 bzw. die Bodenplatte 2 oder die Deckplatte 3 an seinen bzw. ihren Randbereichen einstückig mit einem Rahmen verbunden sein. Ein solcher Rahmen ist vorteilhafterweise in einer Form ausgebildet, wie sie von standardisierten Mikrotiterplatten bekannt ist.

Die Bodenplatte 2 und die Deckplatte 3 sind vorteilhafterweise aus Polymethylmetacrylat hergestellt. Möglich sind aber auch Kunststoffe wie Polycarbonat, Polystyrol, Polysulfon und Cycloolefin-Copolymer. Vorteilhaft ist es jedenfalls, wenn zumindest eine der beiden Platten aus einem durchsichtigen Kunststoff ausgebildet ist, da dadurch die Reaktionen in den Analyseeinrichtungen 6 von außen detektiert werden können.

Die Oberflächen 4, 5 der Bodenplatte 2 und der Deckplatte 3 werden beispielsweise durch Methoden wie Verkleben, das Aufbringen von polymerisierbaren Bindemitteln, thermisches Versiegeln, Ultraschallschweißen oder Laserschweißen verbunden. Vorteilhaft erfolgt diese Verbindung der Bodenplatte 2 und der Deckplatte 3 durch kurzzeitige Behandlung mit einem Lösungsmittel, so daß sich die Oberflächen 4, 5 geringfügig anlösen und nach Zusammenfügen der Bodenplatte 2 und der Deckplatte 3 fest miteinander verbinden.

Die Fig. 3 zeigt eine Prinzipdarstellung einer Analyseeinrichtung 6, wie sie im Grundkörper 1 (Fig. 1) der Analysevorrichtung mehrfach ausgebildet ist. Die Analyseeinrichtung 6 besteht aus vier Reservoirs 10, wobei zwei Reservoirs 10 durch einen Kanal 13 und zwei weitere Reservoirs 10 durch einen Kanal 14 miteinander strömungsverbunden sind. Der Kanal 13 und der Kanal 14 kreuzen einander in einem gemeinsamen Kreuzungsbereich 15.

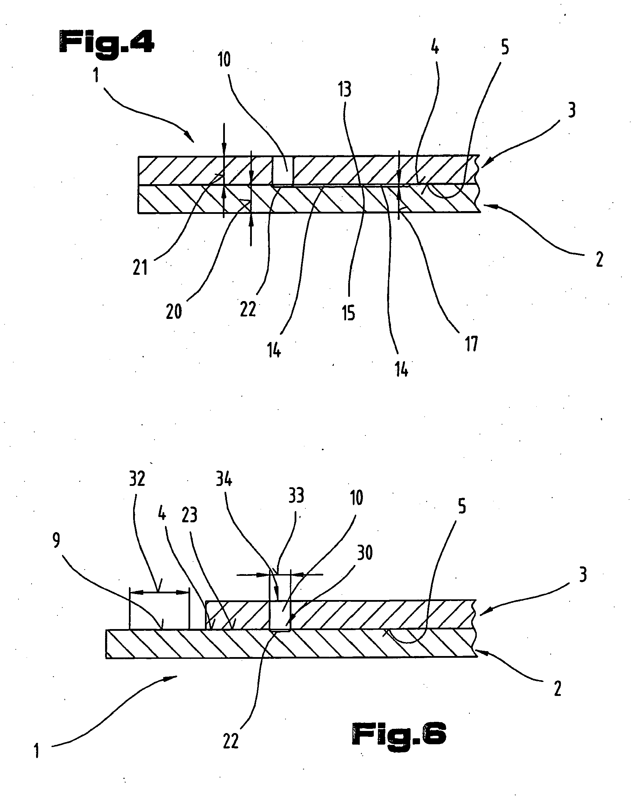

Die beiden Kanäle 13 und 14 sind als sogenannte Mikrokanäle ausgeführt und haben eine Breite 16 von 200 µm und eine Tiefe 17 (Fig. 4) von 100 µm. Vorteilhaft sind Querschnitte der Kanäle 13, 14 mit einer Breite 16 in einem Bereich kleiner als 200 µm und einer Tiefe 17 in einem Bereich kleiner als 100 µm. Der meanderförmig ausgebildete Teil des Kanals 14 zwischen dem an seinem einen Endbereich befindlichen Reservoir 10 und dem Kreuzungsbereich 15 hat eine Länge von ca. 40 mm.

Eine derartige Analyseeinrichtung 6 ist zur Durchführung von Untersuchungen unter Anwendung der Methode der Kapillarelektrophorese geeignet. Dafür wird zunächst in einem ersten Schritt durch ein Reservoir 10 eine Pufferlösung oder ein Gel zugeführt, die durch die Kapillarwirkung der Kanäle 13 und 14 die Kanäle 13 und 14 und die Reservoirs 10 an deren Enden erfüllt. In eines der beiden Reservoirs 10, die durch den Kanal 13 miteinander verbunden sind, wird sodann die Probe gefüllt und durch Anlegen einer Spannung an den beiden durch den Kanal 13 miteinander verbundenen Reservoirs 10 erreicht, daß sich die Probe durch den Kanal 13 in Richtung des Kreuzungsbereiches 15 fortbewegt. Sobald der überwiegende Teil des Kanals 13, aber jedenfalls der Kreuzungsbereich 15 mit der Probenflüssigkeit gefüllt ist, wird nun in einem zweiten Schritt zwischen den beiden Reservoirs 10, die durch den Kanal 14 miteinander verbunden sind, eine elektrische Spannung angelegt, so daß das sich im Kreuzungsbereich befindliche Probenvolumen, das etwa 500 pl entspricht, dazu veranlaßt wird, sich in Richtung des meanderförmig ausgebildeten Teiles des Kanals 14 fortzubewegen.

Bedingt durch die unterschiedliche elektrische Ladung und die unterschiedliche Größe der Molekülteile, die in der Probe enthalten sind, kommt es während der Bewegung durch den Kanal 14 zu einer immer größer werdenden Separation unterschiedlicher Probenbestandteile, je weiter sich das Probenvolumen vom Kreuzungsbereich 15 entfernt hat. Bedingt durch die unterschiedlichen Molekülgrößen und die unterschiedlichen elektrischen Ladungen der verschiedenen Probenbestandteile ist auch deren Beweglichkeit in der Pufferlösung oder dem Gel unterschiedlich und trotz gleicher elektrischer Spannung legen unterschiedliche Probenbestandteile in der gleichen Zeit unterschiedliche Wege zurück. Die Aufspaltung der unterschiedlichen Probenbestandteile über die Länge des Kanals 14 hinweg kann durch ein geeignetes Detektionsverfahren gemessen werden und können so die Bestandteile der Probe identifiziert werden.

Die Fig. 4 zeigt einen Schnitt einer Analysevorrichtung gemäß Fig. 1. Der Grundkörper 1 der Analysevorrichtung besteht aus der Bodenplatte 2 und der Deckplatte 3, wobei die Bodenplatte 2 mit einer Dicke 20 von ca. 2 mm und die Deckplatte 3 mit der Dicke 21 von ebenfalls ca. 2 mm ausgebildet sind. Vorteilhaft sind Dicken 20, 21 in einem Bereich kleiner als 2 mm, bevorzugt in einem Bereich kleiner als 1 mm. In der Deckplatte 3 befindet sich ein Reservoir 10, das als zylinderförmiger Durchgang ausgebildet ist. In der Oberfläche 4 der Bodenplatte 2 sind die Kanäle 13 und 14 mit einer Tiefe 17 von 50 µm ausgebildet. An den Endbereichen der Kanäle 13 und 14 schließen sich Reservoirböden 22 an, die ebenfalls mit der Tiefe 17 ausgebildet sind. Die Reservoirs 10 sind somit mit den Kanälen 13, 14 strömungsverbunden. Die Herstellung der Kanäle 13 und 14 und der Reservoirböden 22 in der Oberfläche 4 erfolgt durch Prägen mit einem entsprechend ausgebildeten Stempel bei erhöhter Temperatur. Alternativ dazu kann deren Herstellung aber auch durch andere Verfahren, wie z.B. Spritzgießen oder Abtragen des Materials mittels Laser durchgeführt werden.

Die Bodenplatte 2 und die Deckplatte 3 sind an ihren Oberflächen 4 und 5 fest verbunden, wobei zumindest Teile der Oberflächen 4 und 5 der Bodenplatte und der Deckplatte, die die Reservoirs und die Kanäle unmittelbar umgeben, flüssigkeitsdicht miteinander verbunden sind. Flüssigkeiten, die in die Reservoirs 10 bzw. die Reservoirböden 22 und die Kanäle 13 und 14 eingebracht werden, können somit nicht zwischen die beiden aneinanderliegenden Oberflächen 4 und 5 eindringen. Dadurch wird vermieden, daß die Homogenität der Strömungsverhältnisse in den Kanälen 13 und 14 gestört wird. Zur Verbindung der beiden Oberflächen 4 und 5 dienen Methoden, wie sie bereits in der Figurenbeschreibung zu den Fig. 1 und 2 aufgeführt worden sind.

Die Ausbildung der Kanäle 13 und 14 kann selbstverständlich auch in der Oberfläche 5 der Deckplatte 3, aber auch teilweise in der Oberfläche 4 der Bodenplatte 2 und teilweise in der Oberfläche 5 der Deckplatte 3 erfolgen. Daß im Grundkörper 1 Analyseeinrichtungen 6 angeordnet sind, ist jedoch nicht darauf eingeschränkt, daß die Kanäle 13 und 14 ausschließlich im Inneren des Grundkörpers 1 ausgebildet sein müssen. Selbstverständlich ist es auch möglich, daß die Kanäle 13 und 14 als Vertiefungen in einer am Grundkörper 1 außenliegenden Oberfläche ausgebildet sind.

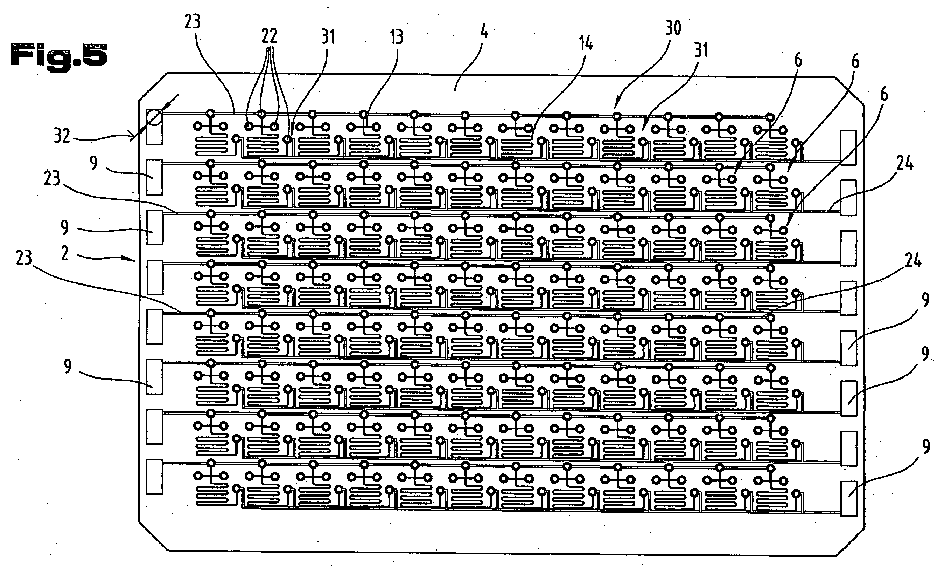

Die Fig. 5 zeigt die Bodenplatte 2. In der Oberfläche 4 der Bodenplatte 2 sind in einem rechtwinkeligen Raster mehrere Einheiten von zu Analyseeinrichtungen 6 gehörenden Kanälen 13 und 14 und Reservoirböden 22, wie in den Beschreibungen zu den Fig. 3 und 4 ausgeführt, ausgebildet. Um zwischen den beiden Reservoirböden 22 in den Endbereichen des Kanals 14 eine elektrische Spannung anlegen zu können, sind an der Oberfläche 4 elektrische Leiter 23 und elektrische Leiter 24 angebracht. Ein erster Endbereich 30 des Leiters 23 ist mit einer der Kontaktstellen 9 an seinem zweiten Endbereich an der Oberfläche 4 der Bodenplatte 2 verbunden. Analog dazu ist der Leiter 24 mit einem ersten Endbereich 31 am Reservoirboden 22 des zweiten Endes des Kanals 14 mit einer weiteren Kontaktstelle 9 verbunden. Somit wird zumindest ein Teil des Reservoirbodens 22 durch den Leiter 23 bzw. 24 gebildet.

Im dargestellten Ausführungsbeispiel sind mehrere gleichartige Reservoirböden 22, d.h. jeweils die Reservoirböden 22 im Endbereich des kürzeren Teils des Kanals 14 von Analyseeinrichtungen 6 einer Zeile, jeweils mit einer gemeinsamen Kontaktstelle 9 elektrisch verbunden. Dies gilt analog für die Reservoirböden 22 im Endbereich des längeren Teiles des Kanals 14, die jeweils in einer Zeile von Analyseeinrichtungen 6 mit dem gleichen Leiter 24 mit einer gemeinsamen Kontaktstelle 9 verbunden sind.

Das Aufbringen der Leiter 23 und 24 und der Kontaktstellen 9 auf der Oberfläche 4 der Bodenplatte 2 erfolgt vorzugsweise durch Bedampfen mit Gold unter Verwendung von entsprechenden Schattenmasken. Es ist somit jeweils ein erster Endbereich der Leiter 23 bzw. 24 mit einem Reservoir 10 verbunden und jeweils ein zweiter Endbereich des Leiters 23 bzw. 24 bildet jeweils eine Kontaktstelle 9. Es ist aber auch möglich, Leiterbahnen auf die Oberfläche 4 aufzukleben oder in entsprechende Vertiefungen einzufügen. Eine weitere Möglichkeit besteht darin, entsprechend ausgeformte Leiterbahnen in Spritzgußformen einzulegen und solcherart an den entsprechenden Spritzgußteil anzuformen.

Als Werkstoff für die Leiter eigenen sich vor allem Metalle wie z.B. Gold oder Platin, aber auch andere elektrisch leitfähige Werkstoffe wie z.B. elektrisch leitfähige Kunststoffe, Leitfähigkeitspasten oder elektrisch leitfähige Lacke.

Die Fig. 6 zeigt einen Schnitt einer Analysevorrichtung mit einer Kontaktstelle 9 gemäß Fig. 1. Mit dem Endbereich 30 des Leiters 23 steht das Reservoir 10 mit der Kontaktstelle 9 an der Oberfläche 4 der Bodenplatte 2, d.h. einer Kontaktstelle 9 an einer Oberfläche des Grundkörpers 1 elektrisch leitend in Verbindung.

Ein Innenkreisdurchmesser 32 der Kontaktfläche der Kontaktstelle 9 ist wesentlich größer als ein Innenkreisdurchmesser 33 einer Öffnung 34 des Reservoirs 10. Dadurch wird das Anlegen der elektrischen Spannung an den Reservoirs 10 wesentlich erleichtert. Gegenüber dem Einführen von Elektroden durch die Öffnungen 34 in die Reservoirs 10 erfordert somit das Anbringen von Elektroden an den Kontaktstellen 9 ein geringeres Maß an mechanischer Genauigkeit. Für das Kontaktieren eines Kontaktes ist nämlich der Innenkreisdurchmesser 32, 33 der Kontaktfläche die bestimmende Größe für die Fehleranfälligkeit des Kontaktierungsvorganges. Das Anbringen von elektrischen Leitern am Grundkörper 1 erlaubt somit eine Vereinfachung der Handhabung der Analysevorrichtungen und somit auch eine Erhöhung von deren Funktionssicherheit, da das Kontaktieren der Kontaktstellen 9 eine geringere mechanische Präzision erfordert.

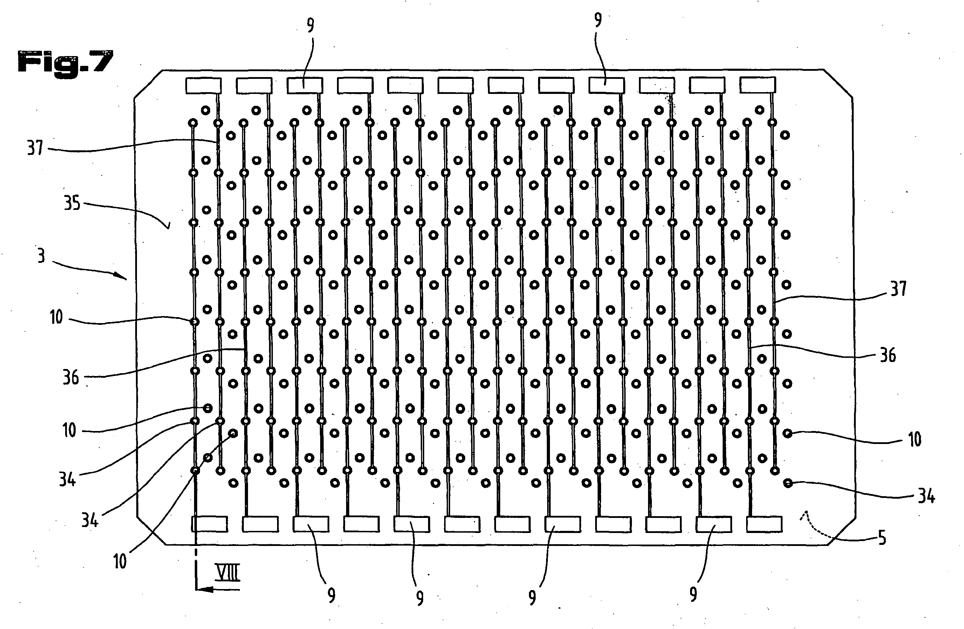

Die Fig. 7 zeigt die Deckplatte 3, wobei eine Oberseite 35, d.h. die der Oberfläche 5 abgewandte Seite der Deckplatte 3 dargestellt ist. An der Oberseite 35 sind von den Analyseeinrichtungen lediglich die Öffnungen 34 der Reservoirs 10 sichtbar.

An der Oberseite 35 der Deckplatte 3 sind Leiter 36 und Leiter 37 angebracht, die jeweils mit Kontaktstellen 9 in elektrisch leitender Verbindung stehen. Diese Leiter 36 und 37 dienen der elektrischen Kontaktierung der Reservoirs 10, die durch den Kanal 13 miteinander verbunden sind (nicht dargestellt).

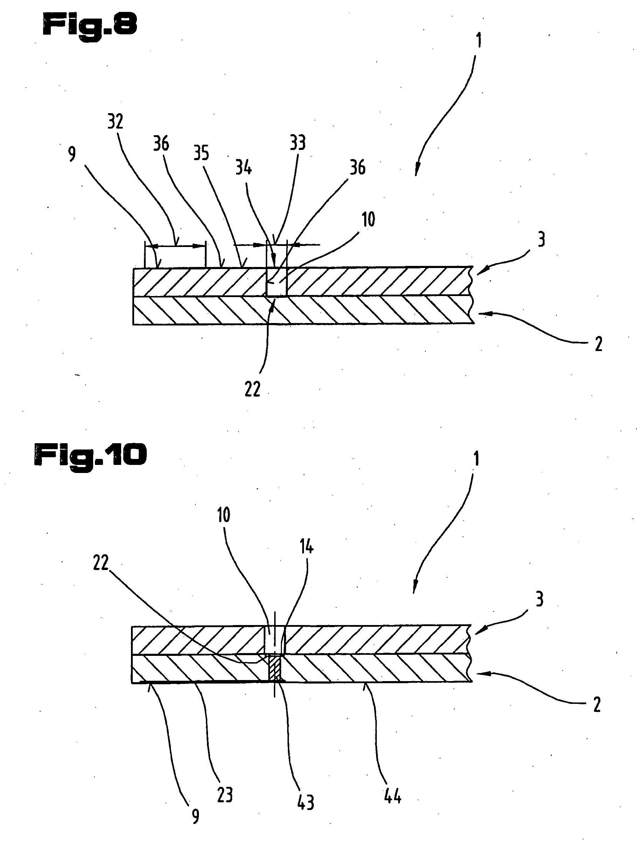

Die Fig. 8 zeigt einen Schnitt einer Analysevorrichtung mit einer Kontaktstelle 9 und Leitern 36 an der Oberseite 35 der Deckplatte 3 gemäß Fig. 1. Durch den elektrischen Leiter 36 ist das Reservoir 10 mit der Kontaktstelle 9 verbunden. Der elektrische Leiter 36 reicht dabei von der Oberseite 35 der Deckplatte 3 durch die Öffnung 34 des Reservoirs 10 an dessen Wänden in dieses hinein. Es ist derart zumindest ein Teil der Reservoirwand durch einen Leiter 36 ausgebildet.

Damit, daß ein Teil der Reservoirwand durch einen Leiter gebildet bzw. daß ein Teil des Reservoirbodens durch den Leiter gebildet ist (Fig. 5 und 6), ist sinngemäß auch gemeint, daß die Reservoirwand bzw. der Reservoirboden mit einem Leiter beschichtet ist.

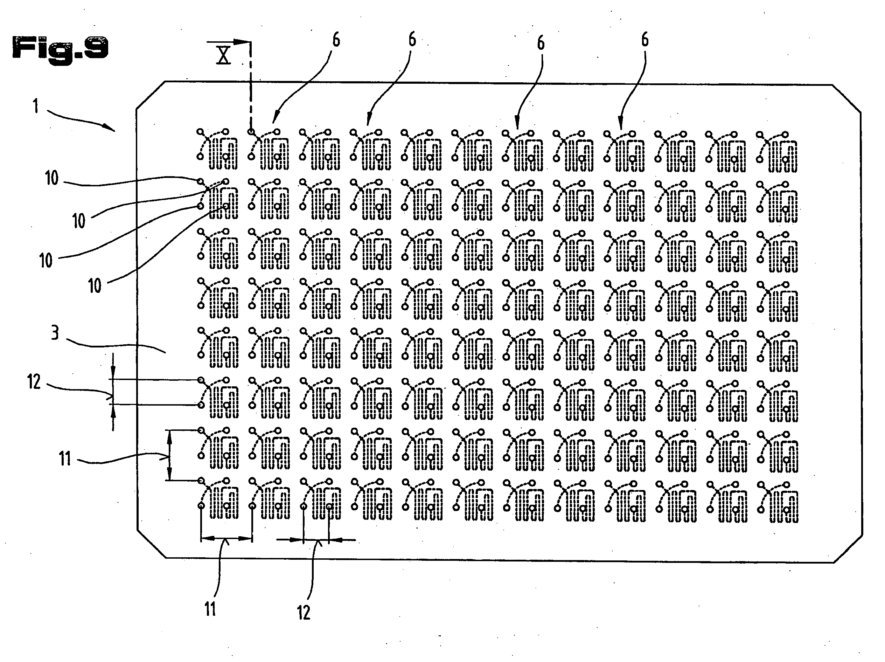

Die Fig. 9 zeigt ein weiteres Ausführungsbeispiel einer Analysevorrichtung mit in einem quadratischen Raster angeordneten Reservoirs 10. In der Deckplatte 3 des Grundkörpers 1 der Analysevorrichtung sind die zu insgesamt 96 Analyseeinrichtungen 6 (teilweise strichliert dargestellt) gehörenden Reservoirs 10 in einem quadratischen Raster angeordnet. Eine Reihenweite 12 der Reservoirs 10 ist dabei gleich einem halben Wert einer Reihenweite 11 der Analyseeinrichtungen 6. Die Analyseeinrichtungen 6 bzw. die Reservoirs 10 sind jeweils gemäß einem Standardraster einer Mikrotiterplatte angeordnet. In der dargestellten Analysevorrichtung hat die Reihenweite 11 einen Wert von 9 mm in Richtung der Längserstreckung des Grundkörpers 1 als auch senkrecht dazu. Die Reihenweite 12 der Reservoirs 10 hat einen Wert von 4,5 mm.

Vorteilhaft an der beschriebenen Anordnung der Reservoirs 10 ist, daß der Abstand eines Reservoirs 10 von den jeweils nächstgelegenen Reservoirs 10 den maximal möglichen Wert hat. Beim Befüllen der Reservoirs 10 mit der Probenflüssigkeit wird damit das Risiko des Überfließens der Probenflüssigkeit zu einem benachbarten Reservoir 10 weitestgehend reduziert.

Die Fig. 10 zeigt einen Schnitt einer Analysevorrichtung gemäß Fig. 9. Dabei ist der erste Endbereich, mit dem der Leiter 23 mit dem Reservoir 10 bzw. dem Reservoirboden 22 elektrisch leitend verbunden ist, durch eine Elektrode 43 ausgebildet. Die Elektrode 43 erstreckt sich dabei zwischen dem Reservoirboden 22 und einer Unterseite 44 der Bodenplatte 2. Durch die Ausbildung der Endbereiche der Leiter 23 als auch der Leiter 24, 36, 37 (nicht dargestellt) durch Elektroden 43, die sich zwischen den Reservoirböden 22 und der Unterseite 44 der Bodenplatte 2 erstrecken, können die Leiter 23, 24; 36, 37 in vorteilhafter Weise an der Unterseite 44 der Bodenplatte 2 angeordnet sein.

Aus den Leitern 23, 24; 36, 37, den Kontaktstellen 9 und den Elektroden 43 bevorzugt jeweils einstückig gebildete Strukturen können in vorteilhafter Weise in bzw. an der Bodenplatte 2 durch einen Spritzgießprozeß angeformt sein.

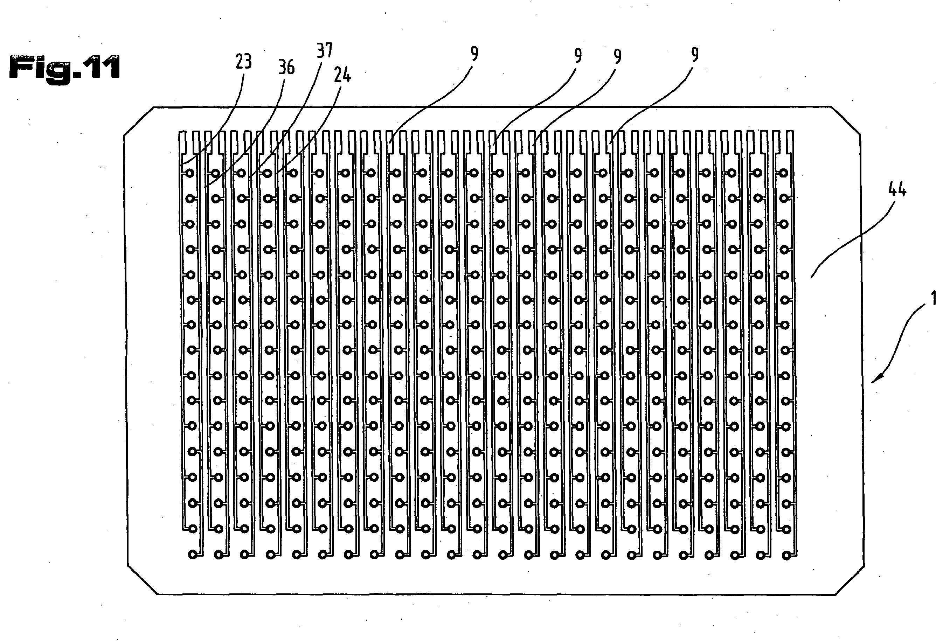

Die Fig. 11 zeigt eine Unterseite der Analysevorrichtung gemäß Fig. 9. Die Leiter 23, 24 und 36, 37 von mehreren Analyseeinrichtungen 6 (nicht dargestellt) führen dabei zur jeweils gleichen Kontaktstelle 9. Die Kontaktstellen 9 sind dabei vorteilhafterweise an einem gemeinsamen Endbereich des Grundkörpers 1 angeordnet. Es ist selbstverständlich aber auch möglich, die Kontaktstellen 9 an unterschiedlichen Endbereichen des Grundkörpers 1 anzuordnen.

In einer alternativen Ausführungsform einer Analysevorrichtung können auch Anordnungen der Leiter, wie sie in den Fig. 5 und 8 beschrieben sind, mit jener Anordnung, wie sie in den Fig. 10 und 11 beschrieben ist, kombiniert sein. D.h. es kann ein Teil der Leiter an der Oberfläche 4 der Bodenplatte 2 (Fig. 5) oder an der Oberseite 35 der Deckplatte 3 (Fig. 7 und 8) angeordnet sein, während ein anderer Teil der Leiter an der Unterseite 44 der Bodenplatte 2 verläuft.

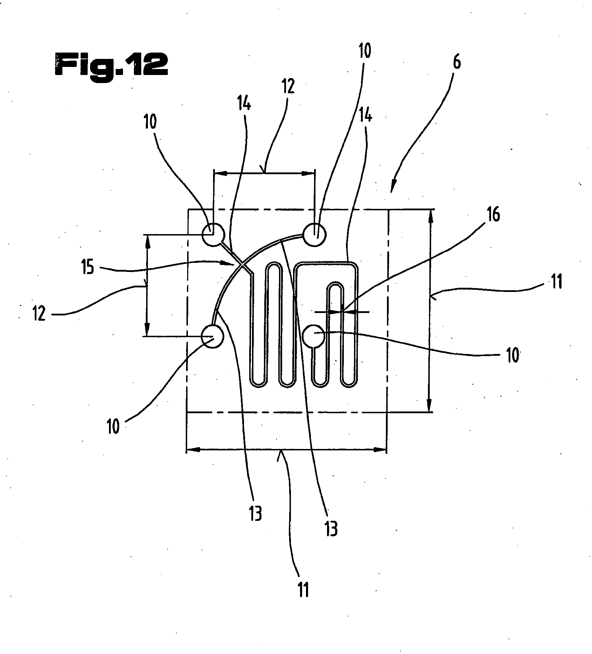

Die Fig. 12 zeigt eine Prinzipdarstellung einer Analyseeinrichtung gemäß Fig. 9. Die Anordnung der Reservoirs 10 ist dabei mit der Reihenweite 12, die dem halben Wert der Reihenwerte 11 von 9 mm entspricht, angeordnet. Der Querschnitt der Kanäle 13 und 14 ist gleich gestaltet wie im Ausführungsbeispiel gemäß Fig. 3 und 4, d.h. die Breite 16 beträgt 100 µm und die Tiefe 17 (Fig. 10) beträgt 50 µm. Eine Analyseeinrichtung 6, wie in Fig. 12 dargestellt, ist ebenfalls zur Durchführung von Untersuchungen mit der Methode der Kapillarelektrophorese geeignet.

Der Ordnung halber sei abschließend darauf hingewiesen, daß zum besseren Verständnis des Aufbaus der Analysevorrichtung diese bzw. deren Bestandteile teilweise unmaßstäblich und/ oder vergrößert und/oder verkleinert dargestellt wurden.
Die den eigenständigen erfinderischen Lösungen zugrundeliegende Aufgabe kann der Beschreibung entnommen werden.

Vor allem können die einzelnen in den Fig. 1, 2, 3, 4, 5, 6, 7, 8; 9, 10, 11, 12 gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

### Bezugszeichenaufstellung

- 1: Grundkörper
- 2: Bodenplatte
- 3: Deckplatte
- 4: Oberfläche
- 5: Oberfläche

- 6: Analyseeinrichtung

- 9: Kontaktstelle
- 10: Reservoir

- 11: Reihenweite
- 12: Reihenweite
- 13: Kanal
- 14: Kanal
- 15: Kreuzungsbereich

- 16: Breite
- 17: Tiefe

- 20: Dicke

- 21: Dicke
- 22: Reservoirboden
- 23: Leiter
- 24: Leiter

- 30: Endbereich

- 31: Endbereich
- 32: Innenkreisdurchmesser
- 33: Innenkreisdurchmesser
- 34: Öffnung
- 35: Oberseite

- 36: Leiter
- 37: Leiter

- 43: Elektrode
- 44: Unterseite

## Patentansprüche

1. Analysevorrichtung umfassend einen Grundkörper (1) mit einer Oberfläche, wobei im Grundkörper eine mikrofluidische Analyseeinrichtung (6) angeordnet ist, wobei die Analyseeinrichtung (6) mit vier Reservoirs (10), die jeweils aus einem Reservoirboden (22) und einer Reservoirwand gebildet sind, ausgebildet ist und jeweils zwei Reservoirs (10) mit einem Kanal (13, 14) verbunden sind und die beiden Kanäle (13, 14) jeweils durch einen gemeinsamen Kreuzungsbereich (15) miteinander verbunden sind und wobei im Grundkörper (1) oder auf der Oberfläche vier elektrische Leiter (23, 24; 36, 37) angeordnet sind, wobei jeweils ein erster Endbereich (30, 31) davon mit jeweils einem der vier Reservoirs (10) verbunden ist und jeweils ein zweiter Endbereich der Leiter (23, 24; 36, 37) mit einer Kontaktstelle (9) an der Oberfläche des Grundkörpers (1) verbunden ist oder diese Kontaktstelle (9) bildet, **dadurch gekennzeichnet, dass** mehrere Analyseeinrichtungen (6) gemäß einem Standardraster einer Mikrotiterplatte angeordnet sind und zumindest ein Teil der Reservoirwand durch den Leiter (23, 24; 36, 37) gebildet ist.

2. Analysevorrichtung nach Anspruch 1, **dadurch gekennzeichnet, dass** der Grundkörper (1) aus einer Bodenplatte (2) und einer Deckplatte (3) gebildet ist, wobei die Bodenplatte (2) und die Deckplatte (3) an Oberflächen (4, 5) miteinander verbunden sind.

3. Analysevorrichtung nach Anspruch 1 oder 2, **dadurch gekennzeichnet, dass** die Leiter (23, 24; 36, 37) mit dem Grundkörper (1) mit einer Verbindungsmethode verbunden sind, wobei die Verbindungsmethode aus einer Gruppe ausgewählt ist, die die Methoden Kleben, Bedampfen, Einfügen in Vertiefungen und Anformen umfasst.

4. Analysevorrichtung nach einem der vorhergehenden Ansprüche, **dadurch gekennzeichnet, dass** zumindest ein Teil des Reservoirbodens (22) durch den Leiter (23, 24; 36, 37) gebildet ist.

5. Analysevorrichtung nach einem der vorhergehenden Ansprüche, **dadurch gekennzeichnet, dass** der erste Endbereich (30, 31) des Leiters (23, 24; 36, 37) durch eine Elektrode (43) ausgebildet ist, die sich zwischen dem Reservoirboden (22) und einer Unterseite (44) der Bodenplatte (2) erstreckt.

6. Analysevorrichtung nach einem der vorhergehenden Ansprüche, **dadurch gekennzeichnet, dass** die Kontaktstellen (9) mit einer Kontaktfläche mit einem Innenkreisdurchmesser (32) und die Reservoirs (10) mit einer Öffnung (34) mit einem Innenkreisdurchmesser (33) ausgebildet sind und der Innenkreisdurchmesser (32) der Kontaktfläche größer ist als der Innenkreisdurchmesser (33) der Öffnungen (34) der Reservoirs (10).

7. Analysevorrichtung nach einem der vorhergehenden Ansprüche, **dadurch gekennzeichnet, dass** die Kontaktstellen (9) nur an einem gemeinsamen Endbereich des Grundkörpers (1) angeordnet sind.

8. Analysevorrichtung nach einem der vorhergehenden Ansprüche, **dadurch gekennzeichnet, dass** die Leiter (23, 24; 36, 37) aus einem Werkstoff bestehen, wobei der Werkstoff aus einer Gruppe ausgewählt ist, die die Materialien Metall, elektrisch leitfähiger Kunststoff, Leitfähigkeitspaste und elektrisch leitfähigen Lack umfasst.

9. Analysevorrichtung nach einem der vorhergehenden Ansprüche, **dadurch gekennzeichnet, dass** der Grundkörper (1) gemäß einer Standardgröße einer Mikrotiterplatte ausgebildet ist.

10. Analysevorrichtung nach einem der vorhergehenden Ansprüche, **dadurch gekennzeichnet, dass** eine vorbestimmbare Anzahl von Analyseeinrichtungen (6) angeordnet ist, wobei die Anzahl aus einer Gruppe ausgewählt ist, die die Zahlen, gebildet durch die mathematische Formel 3 x 2^{N}, wobei N eine natürliche Zahl ist, umfasst.

11. Analysevorrichtung nach einem der vorhergehenden Ansprüche, **dadurch gekennzeichnet, dass** 96 Analyseeinrichtungen (6) angeordnet sind.

12. Analysevorrichtung nach einem der vorhergehenden Ansprüche, **dadurch gekennzeichnet, dass** der Kanal (13, 14) als ein Mikrokanal ausgebildet ist.

13. Analysevorrichtung nach einem der vorhergehenden Ansprüche, **dadurch gekennzeichnet, dass** die vier Reservoirs (10) gemäß einem Standardraster einer Mikrotiterplatte angeordnet sind.

14. Analysevorrichtung nach einem der vorhergehenden Ansprüche, **dadurch gekennzeichnet, dass** eine Reihenweite (12) der vier Reservoirs (10) gleich ist einem halben Wert einer Reihenweite (11) der Analyseeinrichtungen (6).

15. Analysevorrichtung nach einem der vorhergehenden Ansprüche, **dadurch gekennzeichnet, dass** die Bodenplatte (2) und die Deckplatte (3) aus Kunststoff bestehen, wobei die Kunststoffe aus einer Gruppe ausgewählt sind, die die Materialien Polymethylmetacrylat, Polycarbonat, Polystyrol, Polysulfon und Cycloolefin-Copolymer umfasst.

16. Analysevorrichtung nach einem der vorhergehenden Ansprüche, **dadurch gekennzeichnet, dass** die Bodenplatte (2) oder die Deckplatte (3) zumindest teilweise lichtundurchlässig ausgebildet ist.

17. Analysevorrichtung nach einem der vorhergehenden Ansprüche, **dadurch gekennzeichnet, dass** der zumindest eine Kanal (13, 14) durch Vertiefungen in zumindest einer der Oberflächen (4, 5) der Bodenplatte (2) und der Deckplatte (3) ausgebildet ist und zumindest jene Teile der Oberflächen (4, 5) der Bodenplatte (2) und der Deckplatte (3), die die Reservoirs (10) und die Kanäle (13, 14) unmittelbar umgeben, mit einer Verbindungsmethode miteinander flüssigkeitsdicht verbunden sind, wobei die Verbindungsmethode aus einer Gruppe ausgewählt ist, die die Methoden Verkleben, Aufbringen von polymerisierbaren Bindemitteln, Haftvermittlung durch temporäre Behandlung mit einem Lösungsmittel, thermisches Versiegeln, Ultraschallschweißen und Laserschweißen umfasst.

## Claims

1. Analysis device comprising a base body (1) with a surface, incorporating a micro-fluid analysis device (6) in the base body, which analysis device (6) is provided with four reservoirs (10), each having a reservoir base (22) and a reservoir wall, and each two reservoirs (10) are connected to a passage (13, 14) and the two passages (13, 14) are respectively connected to one another by a common cross-over region (15), and four electric conductors (23, 24; 36, 37) are disposed in the base body (1) or on the surface, and a first end region (30, 31) thereof in each case is connected respectively to one of the four reservoirs (10) and a second end region of the conductors (23, 24; 36, 37) is connected in each case to a contact point (9) on the surface of the base body (1) or forms this contact point (9), **characterised in that** several analysis devices (6) are disposed in a standard pattern of a microtitre plate and at least a part of the reservoir wall is formed by the conductor (23, 24; 36, 37).

2. Analysis device as claimed in claim 1, **characterised in that** the base body (1) is formed by a base plate (2) and a cover plate (3), and the base plate (2) and cover plate (3) are joined to one another at surfaces (4, 5).

3. Analysis device as claimed in claim 1 or 2, **characterised in that** the conductors (23, 24; 36, 37) are joined to the base body (1) by a joining method, which joining method is selected from a group comprising the methods of bonding, vapour deposition, fitting in recesses and integral moulding.

4. Analysis device as claimed in one of the preceding claims, **characterised in that** at least a part of the reservoir base (22) is formed by the conductor (23, 24; 36, 37).

5. Analysis device as claimed in one of the preceding claims, **characterised in that** the first end region (30, 31) of the conductor (23, 24; 36, 37) is provided in the form of an electrode (43) which extends between the reservoir base (22) and a bottom face (44) of the base plate (2).

6. Analysis device as claimed in one of the preceding claims, **characterised in that** the contact points (9) are provided with a contact surface with an internal circle diameter (32) and the reservoirs (10) are provided with an orifice (34) with an internal circle diameter (33), and the internal circle diameter (32) of the contact surface is bigger than the internal circle diameter (33) of the orifices (34) of the reservoirs (10).

7. Analysis device as claimed in one of the preceding claims, **characterised in that** the contact points (9) are disposed on a common end region of the base body (1) only.

8. Analysis device as claimed in one of the preceding claims, **characterised in that** the conductors (23, 24; 36, 37) are made from a material, which material is selected from a group of materials comprising metal, electrically conductive synthetic material and electrically conductive varnish.

9. Analysis device as claimed in one of the preceding claims, **characterised in that** the base body (1) is designed to the standard size of a microtitre plate.

10. Analysis device as claimed in one of the preceding claims, **characterised in that** a predefinable number of analysis devices (6) is provided, which number is selected from a group comprising the numbers obtained on the basis of the mathematical formula 3 x 2^{N}, in which N is a natural number.

11. Analysis device as claimed in one of the preceding claims, **characterised in that** 96 analysis devices (6) are provided.

12. Analysis device as claimed in one of the preceding claims, **characterised in that** the passage (13, 14) is provided in the form of a micro-passage.

13. Analysis device as claimed in one of the preceding claims, **characterised in that** the four reservoirs (10) are disposed in a standard pattern of a microtitre plate.

14. Analysis device as claimed in one of the preceding claims, **characterised in that** a row width (12) of the four reservoirs (10) is the same as a half width of a row width (11) of the analysis devices (6).

15. Analysis device as claimed in one of the preceding claims, **characterised in that** the base plate (2) and the cover plate (3) are made from plastic and the plastic is selected from a group of materials comprising polymethyl methacrylate, polycarbonate, polystyrene, polysulphone and cyclo-olefin copolymer.

16. Analysis device as claimed in one of the preceding claims, **characterised in that** the base plate (2) or the cover plate (3) is at least partially transparent.

17. Analysis device as claimed in one of the preceding claims, **characterised in that** the at least one passage (13, 14) is provided in the form of recesses in at least one of the surfaces (4, 5) of the base plate (2) and the cover plate (3) and at least those parts of the surfaces (4, 5) of the base plate (2) and the cover plate (3) immediately surrounding the reservoirs (10) and the passages (13, 14) are joined to one another so as to be fluid-tight by a joining method selected from the methods of bonding, applying polymerisable binding agents, imparting adhesion by temporary treatment with a solvent, thermal sealing, ultrasound welding and laser welding.

## Revendications

1. Dispositif d'analyse comprenant un corps de base (1) avec une surface, où est disposée dans le corps de base une installation d'analyse micro-fluidique (6) où l'installation d'analyse (6) présente quatre réservoirs (10), formés chacun par un fond de réservoir (22) et une paroi de réservoir, et à chaque fois deux réservoirs (10) sont reliés à un canal (13, 14), et les deux canaux (13, 14) sont reliés entre eux à chaque fois par une zone de croisement commune (15), et où sont disposés dans le corps de base (1) ou sur la surface quatre conducteurs électriques (23, 24; 36, 37), où à chaque fois une première zone d'extrémité (30, 31) de ceux-ci est reliée à l'un des, quatre réservoirs (10), et à chaque fois une seconde zone d'extrémité des conducteurs (23, 24; 36, 37) est reliée à un emplacement de contact (9) à la surface du corps de base (1) ou bien forme cet emplacement de contact (9), **caractérisé en ce que** plusieurs installations d'analyse (6) sont disposées selon une trame standard d'une plaque de microtitrage, et au moins une partie de la paroi du réservoir est formée par le conducteur (23, 24; 36, 37).

2. Dispositif d'analyse selon la revendication 1, **caractérisé en ce que** le corps de base (1) est constitué d'une plaque de fond (2) et d'une plaque de recouvrement (3), où la plaque de fond (2) et la plaque de recouvrement (3) sont reliées entre elles aux surfaces (4, 5).

3. Dispositif d'analyse selon la revendication 1 ou 2, **caractérisé en ce que** les conducteurs (23, 24; 36, 37) sont reliés au corps de base (1) par une méthode d'assemblage, où la méthode d'assemblage est sélectionnée d'un groupe comprenant les méthodes collage, métallisation au vide, insertion dans les creux et rapporté par formage.

4. Dispositif d'analyse selon l'une des revendications précédentes, **caractérisé en ce qu'**au moins une partie du fond de réservoir (22) est formée par le conducteur (23, 24; 36, 37).

5. Dispositif d'analyse selon l'une des revendications précédentes, **caractérisé en ce que** la première zone d'extrémité (30, 31) du conducteur (23, 24; 36, 37) est formée par une électrode (43) qui s'étend entre le fond du réservoir (22) et un côté inférieur (44) de la plaque de fond (2).

6. Dispositif d'analyse selon l'une des revendications précédentes, **caractérisé en ce que** les emplacements de contact (9) sont réalisés avec une face de contact avec un diamètre circulaire intérieur (32) et les réservoirs (10) avec une ouverture (34) avec un diamètre circulaire intérieur (33), et le diamètre circulaire intérieur (32) de la face de contact est plus grand que le diamètre circulaire intérieur (33) des ouvertures (34) des réservoirs (10).

7. Dispositif d'analyse selon l'une des revendications précédentes, **caractérisé en ce que** les emplacements de contact (9) sont disposés seulement à une zone d'extrémité commune du corps de base (1).

8. Dispositif d'analyse selon l'une des revendications précédentes, **caractérisé en ce que** les conducteurs (23, 24; 36, 37) sont constitués d'un matériau, où le matériau est sélectionné dans un groupe qui comprend les matériaux métal, matériau synthétique électriquement conducteur, pâte conductrice et vernis électriquement conducteur.

9. Dispositif d'analyse selon l'une des revendications précédentes, **caractérisé en ce que** le corps de base (1) est réalisé en une grandeur standard d'une plaque de microtitrage.

10. Dispositif d'analyse selon l'une des revendications précédentes, **caractérisé en ce qu'**un nombre prédéfinissable d'installations d'analyse (6) est disposé, où le nombre est sélectionné dans un groupe qui comprend les chiffres, formés par la formule mathématique 3 x 2^{N}, où N est un nombre naturel.

11. Dispositif d'analyse selon l'une des revendications précédentes, **caractérisé en ce que** 96 installations d'analyse (6) sont disposées.

12. Dispositif d'analyse selon l'une des revendications précédentes, **caractérisé en ce que** le canal (13, 14) est réalisé comme un microcanal.

13. Dispositif d'analyse selon l'une des revendications précédentes, **caractérisé en ce que** les quatre réservoirs (10) sont disposés selon une trame standard d'une plaque de microtitrage.

14. Dispositif d'analyse selon l'une des revendications précédentes, **caractérisé en ce qu'**une largeur de rangée (12) des quatre réservoirs (10) est égale à une demi-valeur d'une largeur de rangée (11) des installations d'analyse (6).

15. Dispositif d'analyse selon l'une des revendications précédentes, **caractérisé en ce que** la plaque de fond (2) et la plaque de recouvrement (3) sont en matériau synthétique, où les matériaux synthétiques sont sélectionnés dans un groupe qui comprend les matériaux polyméthylmétacrylate, polycarbonate, polystyrène, polysulfone et le copolymère de cyclooléfine.

16. Dispositif d'analyse selon l'une des revendications précédentes, **caractérisé en ce que** la plaque de fond (2) ou la plaque de recouvrement (3) est au moins partiellement imperméable à la lumière.

17. Dispositif d'analyse selon l'une des revendications précédentes, **caractérisé en ce qu'**au moins un canal (13, 14) est réalisé par des creux dans au moins l'une des surfaces (4, 5) de la plaque de fond (2) et de la plaque de recouvrement (3), et au moins les parties de surface (4, 5) de la plaque de fond (2) et de la plaque de recouvrement (3), qui entourent les réservoirs (10) et les canaux (13, 14) directement, sont reliées entre elles par une méthode d'assemblage d'une manière étanche au liquide, où la méthode d'assemblage est sélectionnée dans un groupe qui comprend les méthodes collage, application de liants polymérisables, adhésion par traitement temporaire avec un solvant, métallisation thermique au vide, soudage à ultra-sons et soudage laser.
